# EUROPEAN PATENT APPLICATION

(11) **EP 4 443 495 A1**
(43) Date of publication of application: **09.10.2024**
(21) Application number: 24168442.2
(22) Date of filing: 04.04.2024
(51) Int. Cl.: H01L 23/48, H01L 25/07

(54) **3D GATE CONTROL CONNECTION OF A POWER MODULE WITH AT LEAST ONE CONTROLLED POWER SEMICONDUCTOR DIE**

(30) Priority: 04.04.2023 US 202363494036 P; 02.04.2024 US 202418624674
(71) Applicant: II-VI Delaware, Inc., Wilmington, DE 19890 (US)
(72) Inventor: TEMESI, Erno, Wilmington, 19890 (US); KEPIRO, Zoltan, Wilmington, 19890 (US); DUPIN, Philippe, Wilmington, 19890 (US)
(74) Representative: Schmidt, Christian

(57) **Abstract**

This disclosure describes a power semiconductor module with at least one controlled power semiconductor bare die on an isolation substrate. The power semiconductor bare die includes a gate and a return control connection associated with pins that extend perpendicularly from the top of the power semiconductor bare die. One or more power terminals are connected to the isolation substrate.

## Description

### CROSS REFERENCE TO RELATED APPLICATIONS

This application claims the benefit of and priority to U.S. Provisional Patent Application No. 63/494,036, titled "3D GATE CONTROL CONNECTION OF A POWER MODULE WITH A CONTROLLED POWER SEMICONDUCTOR DIE," filed April 4, 2023, the disclosure of which is incorporated herein by reference in its entirety.

### BACKGROUND

Limitations and disadvantages of traditional devices for electrically connecting an electronic module and electronic assembly will become apparent to one of skill in the art, through comparison of such approaches with some aspects of the present method and system set forth in the remainder of this disclosure with reference to the drawings.

### BRIEF SUMMARY

Systems and methods are provided for control pins on the top of semiconductor die to avoid electromagnetic coupling, substantially as illustrated by and/or described in connection with at least one of the figures, as set forth more completely in the claims.

### BRIEF DESCRIPTION OF THE DRAWINGS

FIG. 1 illustrates a first example power semiconductor module in accordance with various example implementations of this disclosure.
FIG. 2 illustrates a second example power semiconductor module in accordance with various example implementations of this disclosure.
FIG. 3 illustrates a third example power semiconductor module in accordance with various example implementations of this disclosure.
FIG. 4 illustrates construction details of the power semiconductor module from FIG. 3 in accordance with various example implementations of this disclosure.

### DETAILED DESCRIPTION

This disclosure describes a 3D gate control connection of a power semiconductor module with at least one controlled power semiconductor die. Systems and methods are provided for control pins on the top of semiconductor die to avoid electromagnetic coupling between the high current commutation circuit (e.g., of a switching circuit) and the semiconductor control circuit. As disclosed, the gate control connection pins are positioned to reduce the coupling effect of the electromagnetic field from the high current commutation circuit on the gate drive circuit and to reduce capacitive and inductive coupling from the high current circuit to the gate drive circuit.

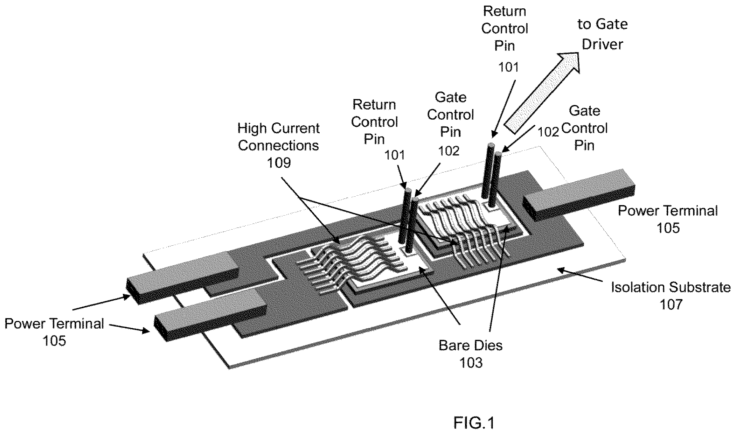

FIG. 1 illustrates a first example power semiconductor module in accordance with various example implementations of this disclosure. The power semiconductor module of FIG. 1 comprises two controlled power semiconductor bare dies 103 on an isolation substrate 107. Each power semiconductor bare die 103 includes one gate control connection pin 102 and one return control connection pin 101 that extend outward and perpendicularly from the top plane of the power semiconductor bare die 103 and/or directly to a gate driver. The gate pin 102 is the connection to gate driver, that is controlling the gate. The return may also be routed via a high current route instead of return control pin 101.

One or more power terminals 105 are connected to the isolation substrate 107 and extend outward from and parallel to the top plane of the isolation substrate 107, as illustrated on FIG.1. While not illustrated, the power terminals 105 may also extend perpendicularly or in any direction from the top plane of the isolation substrate 107.

The controlled power semiconductor bare dies 103 may also comprise high current connections 109 located on the top plane of the controlled power semiconductor bare die 103. The high current connections 109 are operably coupled to the isolation substrate 107. In FIG.1 the high current connections 109 are illustrated as wire bonds.

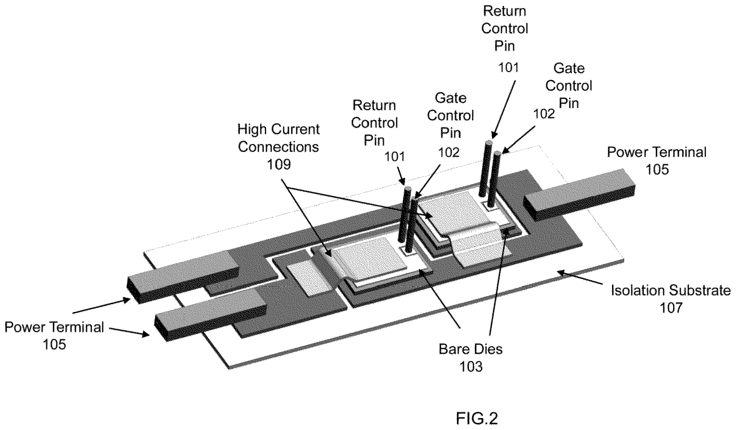

FIG. 2 illustrates a second example power semiconductor module in accordance with various example implementations of this disclosure.

The power semiconductor module of FIG. 2 is similar in many ways to the power semiconductor module of FIG. 1. One difference, however, is that the high current connections 109 of FIG.2 are illustrated as metal clips connected to isolation substrate 107.

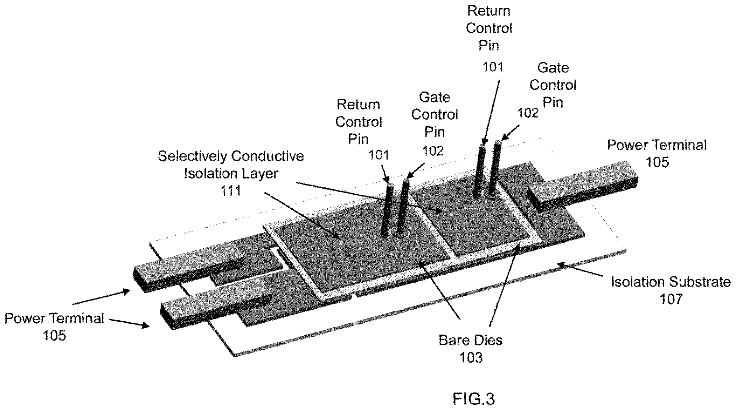

FIG. 3 illustrates a third example power semiconductor module in accordance with various example implementations of this disclosure.

The power semiconductor module of FIG. 3 is similar in many ways to the power semiconductor module of FIG. 1. One difference, however, is that the gate 102 and the return control connection 101 as well as the high current connections 109 are operably coupled to the controlled power semiconductor bare die via a selectively conductive isolation layer 111. The third example power semiconductor module may comprise flexible PCB, POL or Kapton isolation foil with conductive layer on top. The top conductive layer may be bonded to the die surface by soldering or by vias through the selective isolation.

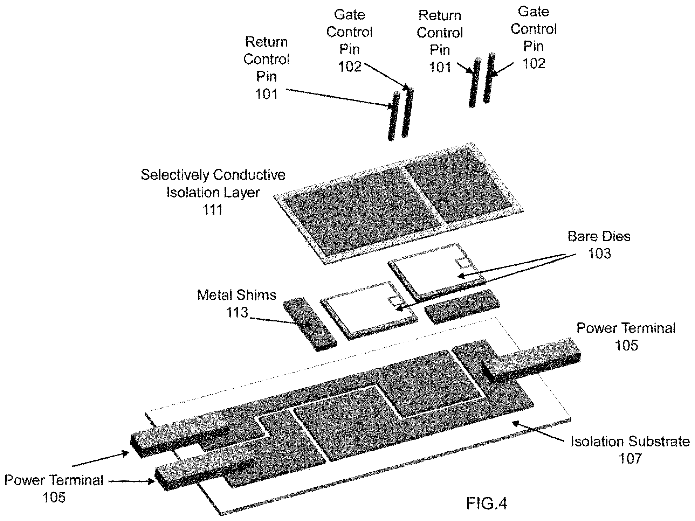

FIG. 4 illustrates the connection system used in the power semiconductor module from FIG. 3. Metal shims 113 are connected between the isolation substrate 107 and the bottom side of the selectively conductive layer 111 to operate the high current connection; the control connections 101, 102 are attached on top of the selectively conductive layer 111, directly to the top plane or by using one or more vias.

A power overlay interconnect (POL) may be used as selectively conductive layer 111.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. A module, comprising:
   an isolation substrate;
   a plurality of semiconductor bare dies operably coupled to the isolation substrate;
   a plurality of high current connections operably coupled from a top plane of the plurality of semiconductor bare dies to the isolation substrate;
   one or more gate control pins operably coupled perpendicularly to the top plane of the plurality of semiconductor bare dies; and
   one or more return control pins operably coupled perpendicularly to the top plane of the plurality of semiconductor bare dies,
   wherein the one or more gate control pins and the one or more return control pins extend directly to a control circuit.
2. The module of aspect 1, wherein the plurality of semiconductor bare dies comprises one or more power semiconductor bare dies.
3. The module of aspect 1, wherein one or more power terminals are operably coupled to the isolation substrate.
4. The module of aspect 1, wherein the plurality of high current connections comprises a plurality of wire bonds.
5. The module of aspect 1, wherein the plurality of high current connections comprises a plurality of metal clips.
6. The module of aspect 1, wherein the one or more gate control pins are operably coupled to one or more semiconductor bare dies of the plurality of semiconductor bare dies via a selectively conductive isolation layer.
7. The module of aspect 1, wherein the one or more return control pins are operably coupled to one or more semiconductor bare dies of the plurality of semiconductor bare dies via a selectively conductive isolation layer.
8. The module of aspect 1, wherein:
   the plurality of high current connections comprises a plurality of metal shims, and
   the plurality of metal shims is coupled to a selectively conductive isolation layer.
9. The module of aspect 1, wherein:
   one of the one or more gate control pins is operably coupled to one of the plurality of semiconductor bare dies, and
   the plurality of semiconductor bare dies operate in parallel.
10. The module of aspect 1, wherein:
   one of the one or more return control pins is operably coupled to one of the plurality of semiconductor bare dies, and
   the plurality of semiconductor bare dies operate in parallel.
11. The module of aspect 1, wherein the module comprises a power overlay interconnect comprising a selectively conductive isolation layer.
12. A method, comprising:
   operably coupling a plurality of semiconductor bare dies to an isolation substrate;
   operably coupling a plurality of high current connections from a top plane of the plurality of semiconductor bare dies to the isolation substrate;
   operably coupling one or more gate control pins perpendicularly to the top plane of the plurality of semiconductor bare dies; and operably coupling one or more return control pins perpendicularly to the top plane of the plurality of semiconductor bare dies, wherein the one or more gate control pins and the one or more return control pins are directly connected to a control circuit.
13. The method of aspect 12, wherein the method comprises:
   operably coupling an additional semiconductor bare die to the isolation substrate;
   operably coupling an additional high current connection from atop plane of the additional semiconductor bare die to the isolation substrate;
   operably coupling an additional gate control pin perpendicularly to the top plane of the additional semiconductor bare die;
   operably coupling an additional return control pin perpendicularly to the top plane of the additional semiconductor bare die; and
   packaging the additional semiconductor bare die with the plurality of semiconductor bare dies such that the additional gate control pin and the additional return control pin are parallel to the one or more gate control pins and the one or more return control pins.
14. The method of aspect 12, wherein the plurality of semiconductor bare dies comprises one or more power semiconductor bare die.
15. The method of aspect 12, comprising operably coupling one or more power terminals to the isolation substrate.
16. The method of aspect 12, wherein the plurality of high current connections comprises a plurality of wire bonds.
17. The method of aspect 12, wherein the plurality of high current connections comprises a plurality of metal clips.
18. The method of aspect 12, wherein the one or more gate control pins are operably coupled to the plurality of semiconductor bare dies via a selectively conductive isolation layer.
19. The method of aspect 12, wherein the one or more return control pins are operably coupled to the plurality of semiconductor bare dies via a selectively conductive isolation layer.
20. The method of aspect 12, wherein:
   the plurality of high current connections comprises a plurality of metal shims, and
   the plurality of metal shims is coupled to a selectively conductive isolation layer.
21. The method of aspect 12, wherein:
   one of the one or more gate control pins is operably coupled to one of the plurality of semiconductor bare dies, and
   the plurality of semiconductor bare dies operate in parallel.
22. The method of aspect 12, wherein:
   one of the one or more return control pins is operably coupled to one of the plurality of semiconductor bare dies, and
   the plurality of semiconductor bare dies operate in parallel.
23. The method of aspect 12, wherein the module comprises a power overlay interconnect comprising a selectively conductive isolation layer.

The present application claims the priorities of U.S. patent applications 63/494,036 filed on April 4, 2023 and 18/624,674 filed on April 2, 2024. The entire disclosure of these applications is hereby explicitly incorporated by reference into the present application.

Implementations disclosed herein may relate to a power semiconductor module with at least one controlled power semiconductor bare die on an isolation substrate. The power semiconductor bare die includes a gate and a return control connection associated with pins that extend perpendicularly from the top of the power semiconductor bare die. One or more power terminals are connected to the isolation substrate.

As used herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As used herein, "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}. As used herein, the term "exemplary" means serving as a non-limiting example, instance, or illustration. As used herein, the terms "e.g.," and "for example" set off lists of one or more non-limiting examples, instances, or illustrations. As used herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.). As used herein, the term "based on" means "based at least in part on." For example, "x based on y" means that "x" is based at least in part on "y" (and may also be based on z, for example).

While the present method and/or system has been described with reference to certain implementations, it will be understood by those skilled in the art that various changes may be made, and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A module, comprising:
an isolation substrate;
a plurality of semiconductor bare dies operably coupled to the isolation substrate;
a plurality of high current connections operably coupled from a top plane of the plurality of semiconductor bare dies to the isolation substrate;
one or more gate control pins operably coupled perpendicularly to the top plane of the plurality of semiconductor bare dies; and
one or more return control pins operably coupled perpendicularly to the top plane of the plurality of semiconductor bare dies,
wherein the one or more gate control pins and the one or more return control pins extend directly to a control circuit.

2. The module of claim 1, wherein the plurality of semiconductor bare dies comprises one or more power semiconductor bare dies.

3. The module of any one of the preceding claims, wherein one or more power terminals are operably coupled to the isolation substrate.

4. The module of any one of the preceding claims, wherein
a) the plurality of high current connections comprises a plurality of wire bonds, and/or wherein
b) the plurality of high current connections comprises a plurality of metal clips.

5. The module of any one of the preceding claims, wherein
a) the one or more gate control pins are operably coupled to one or more semiconductor bare dies of the plurality of semiconductor bare dies via a selectively conductive isolation layer, and/or wherein
b) the one or more return control pins are operably coupled to one or more semiconductor bare dies of the plurality of semiconductor bare dies via a selectively conductive isolation layer.

6. The module of any one of the preceding claims, wherein:
the plurality of high current connections comprises a plurality of metal shims, and
the plurality of metal shims is coupled to a selectively conductive isolation layer.

7. The module of any one of the preceding claims, wherein:
a) one of the one or more gate control pins is operably coupled to one of the plurality of semiconductor bare dies, and
the plurality of semiconductor bare dies operate in parallel, and/or wherein:
b) one of the one or more return control pins is operably coupled to one of the plurality of semiconductor bare dies, and
the plurality of semiconductor bare dies operate in parallel.

8. The module of any one of the preceding claims, wherein the module comprises a power overlay interconnect comprising a selectively conductive isolation layer.

9. A method, comprising:
operably coupling a plurality of semiconductor bare dies to an isolation substrate;
operably coupling a plurality of high current connections from a top plane of the plurality of semiconductor bare dies to the isolation substrate;
operably coupling one or more gate control pins perpendicularly to the top plane of the plurality of semiconductor bare dies; and operably coupling one or more return control pins perpendicularly to the top plane of the plurality of semiconductor bare dies, wherein the one or more gate control pins and the one or more return control pins are directly connected to a control circuit.

10. The method of claim 9, wherein the method comprises:
operably coupling an additional semiconductor bare die to the isolation substrate;
operably coupling an additional high current connection from atop plane of the additional semiconductor bare die to the isolation substrate;
operably coupling an additional gate control pin perpendicularly to the top plane of the additional semiconductor bare die;
operably coupling an additional return control pin perpendicularly to the top plane of the additional semiconductor bare die; and
packaging the additional semiconductor bare die with the plurality of semiconductor bare dies such that the additional gate control pin and the additional return control pin are parallel to the one or more gate control pins and the one or more return control pins.

11. The method of any one of claims 9 to 10, wherein the plurality of semiconductor bare dies comprises one or more power semiconductor bare die.

12. The method of any one of claims 9 to 11, comprising operably coupling one or more power terminals to the isolation substrate.

13. The method of any one of claims 9 to 12, wherein
a) the plurality of high current connections comprises a plurality of wire bonds, and/or wherein
b) the plurality of high current connections comprises a plurality of metal clips, and/or wherein
c) the one or more gate control pins are operably coupled to the plurality of semiconductor bare dies via a selectively conductive isolation layer, and/or wherein
d) the one or more return control pins are operably coupled to the plurality of semiconductor bare dies via a selectively conductive isolation layer, and/or wherein
e) one of the one or more gate control pins is operably coupled to one of the plurality of semiconductor bare dies, and
the plurality of semiconductor bare dies operate in parallel, and/or wherein
f) one of the one or more return control pins is operably coupled to one of the plurality of semiconductor bare dies, and
the plurality of semiconductor bare dies operate in parallel.

14. The method of any one of claims 9 to 13, wherein:
the plurality of high current connections comprises a plurality of metal shims, and
the plurality of metal shims is coupled to a selectively conductive isolation layer.

15. The method of any one of claims 9 to 14, wherein the module comprises a power overlay interconnect comprising a selectively conductive isolation layer.
